(19) Europäisches Patentamt

European Patent Office

Office européen des brevets

(11) EP 0 818 786 A2

(12) **EUROPÄISCHE PATENTANMELDUNG**

(43) Veröffentlichungstag:
14.01.1998 Patentblatt 1998/03

(51) Int. Cl.⁶: **G11C 7/00**

(21) Anmeldenummer: 97110324.7

(22) Anmeldetag: 24.06.1997

(84) Benannte Vertragsstaaten:
AT BE CH DE DK ES FI FR GB GR IE IT LI LU MC NL PT SE
Benannte Erstreckungsstaaten:
AL LT LV RO SI

(30) Priorität: 09.07.1996 DE 19627634

(71) Anmelder:
SIEMENS AKTIENGESELLSCHAFT
80333 München (DE)

(72) Erfinder:
• Kleine, Ulrich
38350 Helmstedt (DE)
• Vogel, Mike
04600 Altenburg (DE)

(54) **CMOS-Schaltung aus CMOS-Schaltungsblöcken, die in bitparallelen Datenpfaden angeordnet sind**

(57)     Die Datenübertragung durch die Datenpfade wird mit Hilfe eines symmetrischen Taktsignales synchronisiert. Um dynamische Hazards zu vermeiden, die durch die unterschiedlichen Verzögerungszeiten bei der Datenübertragung in den Datenpfaden entstehen, wird in jedem Datenpfad jeweils ein Zwischenspeicherelement angeordnet, das die empfangenen Datensignale erst gegen Ende des zur Synchronisation der Datenübertragung verwendeten Impulses des Taktsignals in die nachfolgenden Schaltungsblöcke weitergibt.

FIG 4

EP 0 818 786 A2

# Beschreibung

In bitparallelen CMOS-Datenpfad-Architekturen treten bedingt durch dynamische Hazards Verlustleistungen auf, die nicht unwesentlich zu der Gesamtverlustleistung beitragen. Die Verlustleistung digitaler statischer CMOS-Schaltungen wird im wesentlichen durch die umzuladenden Ladungen der Transistorkapazitäten und der Übertragungskapazitäten bestimmt. Näherungsweise gilt für die Verlustleistung $P_t$

$$P_t \cong \sigma C_L V_{DD}^2 f_c$$

Dabei bedeutet $C_L$ die umzuladende Transistor- und Übertragungskapazität, $V_{DD}$ die Versorgungsspannung, $f_c$ die Taktfrequenz und $\sigma$ die Schaltwahrscheinlichkeit.

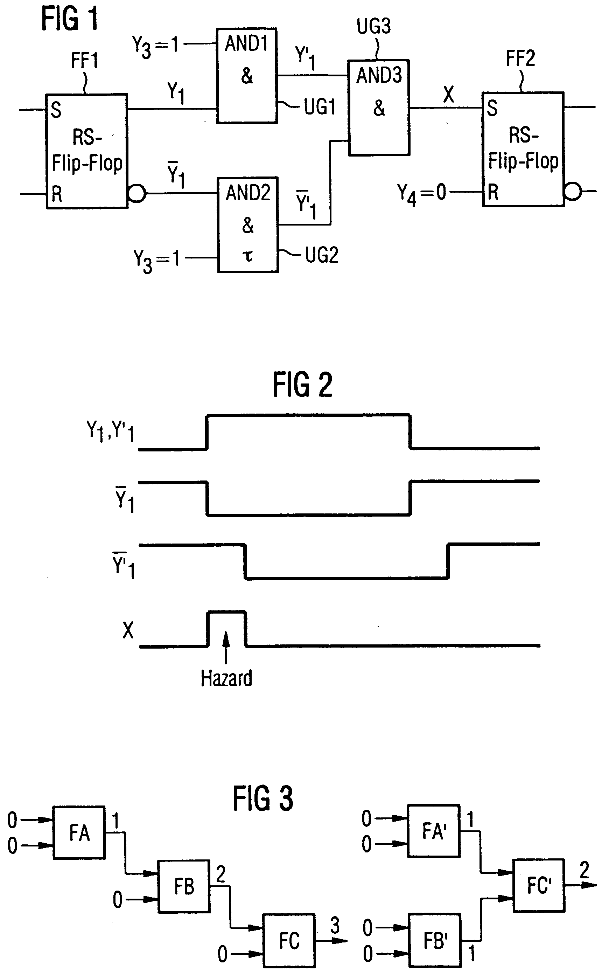

Statische Hazards sind als logische Fehler in digitalen Schaltungen definiert, die durch die unterschiedlichen Laufzeiten der verwendeten Gatter entstehen. Ein einfaches Beispiel hierfür ist aus Fig. 1 zu entnehmen. Hier ist eine Schaltung aus CMOS-Schaltungsblöcken gezeigt, die im wesentlichen aus UND-Gattern UG und bistabilen Kippschaltungen FF besteht. Die Signale Y, X innerhalb des Schaltungsblockes der Fig. 1, soweit sie variabel sind, sind in Fig. 2 dargestellt. Es sei angenommen, daß sich die Signale Y1 und $\overline{Y_T}$ gleichzeitig auf logisch "1" bzw. logisch "0" ändern. Am Ausgang der UND-Gatter UG1 und UG2 erscheinen dann die entsprechenden Signale Y1' und $\overline{Y}$ '. Wird angenommen, daß das UND-Gatter UG2 mit der Verzögerung $\tau$ schaltet und das UND-Gatter UG1 verzögerungsfrei, so erscheint am Ausgang des UND-Gatters UG3 als Signal X eine temporäre logische "1", die zu einem nicht gewollten Setzen der nachfolgenden bistabilen Kippschaltung FF2 führt. Sind die Schaltgeschwindigkeiten der beiden UND-Gatter UG1 und UG2 gleich, tritt kein Hazard auf. In Fig. 2, letzte Zeile, ist der Hazard X am Ausgang des UND-Gatters UG3 dargestellt,der wegen der Verzögerung $\tau$ des UND-Gatters UG2 auftritt.

Als dynamische Hazards werden Schaltvorgänge bezeichnet, bei denen der Ausgang eines Gatters, bedingt durch unterschiedliche Laufzeiten, mehrmals schaltet, bevor es seinen endgültigen logischen zustand erreicht.

Bisher wurden verschiedene Wege gegangen, um die Schaltvorgänge in digitalen Schaltungen zu reduzieren [1, 2]. Eine Möglichkeit besteht darin, die Anzahl der für eine Realisierung einer Funktion erforderlichen logischen Gatter zu miniieren]. Dabei werden in der Regel indirekt auch die dynamischen Hazards reduziert. Weiterhin wurden spezielle Programme zur Minimierung der Schalthäufigkeit und damit zur Reduzierung der Verlustleistung entwickelt[3, 4]. Eine Strategie zur Minimierung der dynamischen Hazards besteht darin, daß versucht wird, alle Signalpfade nach Möglichkeit gleich lang zu machen. Dieser Weg ist in Fig. 3 dargestellt. Hier sind Schaltungen aus drei Schaltungsblöcken FA,FB,FC gezeigt. Während in der linken Schaltung an den Ausgängen 2 und 3 dynamische Hazards auftreten können, treten bei der rechten Schaltung unter der Bedingung, daß die Signallaufzeiten der Blöcke FA' und FB' gleich sind, keine dynamischen Hazards mehr auf.

Das der Erfindung zugrundeliegende Problem besteht darin, bei einer CMOS-Schaltung aus CMOS-Schaltungsblöcken, die in bitparallelen Datenpfaden angeordnet sind, die Schaltvorgänge zu reduzieren, um damit die Wahrscheinlichkeit des Auftretens von Hazards zu verringern. Dieses Problem wird gemäß den Merkmalen des Patentanspruches 1 gelöst.

Dadurch, daß in den Datenpfaden Zwischenspeicherelemente, z.B. Latches, angeordnet werden, die die übertragenen Daten zwischenspeichern, und daß diese Zwischenspeicherelemente mit einem unsymmetrischen Takt angesteuert werden, wird erreicht, daß die Daten von den Zwischenspeicherelementen in die Datenpfade hinein zu einem Zeitpunkt übertragen werden, zu dem die von vorhergehenden Schaltungsblöcken empfangenen Daten bereits sicher gespeichert worden waren. Die Folge ist, daß die Daten am Ausgang der Zwischenspeicherelemente zum gleichen Zeitpunkt erscheinen und somit in nachfolgenden Schaltungsblöcken keine Hazards mehr auftreten können.

Weiterbildungen der Erfindung ergeben sich aus den Unteransprüchen.

Anhand eines Ausführungsbeispieles wird die Erfindung weiter erläutert. Es zeigen

Fig. 4 einen typischen Ausschnitt aus einer bitparallelen Datenpfadschaltung mit CMOS-Schaltungsblöcken,

Fig. 5 ein Taktimpulsdiagramm, das die Taktsignale zur Ansteuerung der Schaltungsblöcke und Zwischenspeicherelemente in der CMOS-Schaltung darstellt

Fig. 6 eine Schaltungsanordnung zur Erzeugung des unsymmetrischen Taktsignales für die Zwischenspeicherelemente.

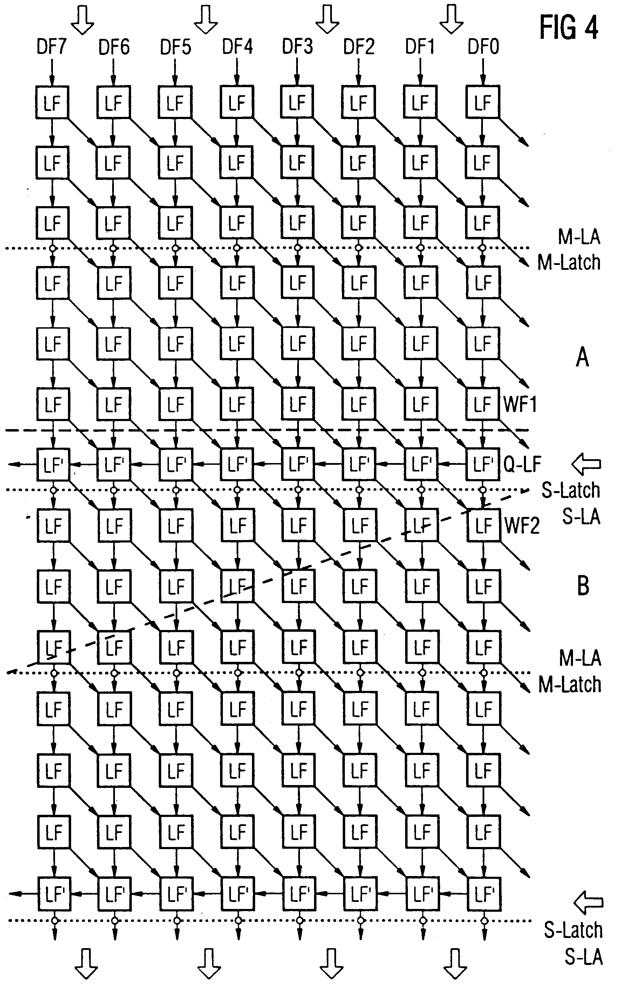

Fig. 4 zeigt einen typischen Ausschnitt aus einer bitparallelen Datenpfadschaltung. Derartige Schaltungsstrukturen treten z.B. in parallelen Multiplizierern, bitparallelen Transversalfiltern, rekursiven Filtern und in Prozessoren auf. Hier sind in den Datenpfaden DF0-DF7 Schaltungsblöcke LF angeordnet. Die Daten können senkrecht durch die Datenpfade DF laufen, sie können aber auch zu benachbarten Datenpfaden weitergeleitet werden. Um den Datenverlauf durch die Datenpfade zu synchronisieren, können in den Datenpfaden Zwischenspeicherelemente, z.B. Master-Slave-Register, angeordnet werden, die von einem Taktsignal CLK angesteuert werden. In Fig. 4 gibt es nach einer gleichen Anzahl von Schaltungsblöcken LF jeweils ein Zwischenspeicherelement und zwar zunächst z.B. ein Master- Zwischenspeicherelement M-LA und wiederum nach einer gleichen Anzahl von weiteren Schaltungsblöcken ein Slave-Zwischenspeicherelement S-LA. Zur Demonstration sind vor den Slave- Zwischenspeicherelementen S-LA Schaltungsblöcke LF' angeordnet, die quer zum Verlauf der Datenpfade eine Datenübertragung zu jeweils benachbarten Schaltungsblöcken erlauben. Diese Reihe von Schaltungsblöcken LF' ist in Fig. 4 mit Q-LF bezeichnet.

Die in den Datenpfaden angeordneten Zwischenspeicherelemente können nach den Master-Slave-Prinzip realisiert sein. Sie werden derart verteilt in einer solchen Architektur angeordnet, daß eine Synchronisierung des Datenflusses durch die Schaltung erreicht wird. Die max. Taktfrequenz ist dann durch die Summe der Signallaufzeiten der Schaltungsblöcke LF zwischen jeweils einem Master- und Slave- Zwischenspeicherelement, des dem Slave- Zwischenspeicherelement folgenden Schaltungsblocks, sowie der Laufzeit eines Master- und eines Slave-Zwischenspeicherelementes gegeben. Die Laufzeit ist dabei unabhängig von der Position der Zwischenspeicherelemente innerhalb der Schaltung.

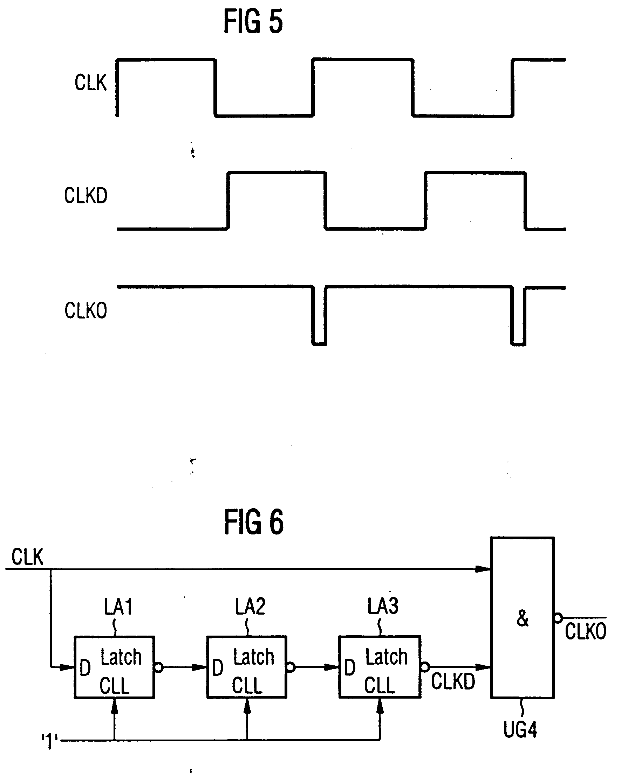

Bei normalem Betrieb der Zwischenspeicherelemente mit einem symmetrischen Taktsignal, das z. B. in Fig. 5 mit CLK bezeichnet ist, wird das Auftreten von dynamischen Hazards sehr stark von der Lage der Zwischenspeicherelemente beeinflußt. Dies kann anhand der Fig. 4 erläutert werden. Hier werden am oberen Rand fortlaufend Daten parallel angelegt (durch die Pfeile angedeutet). Da die Laufzeiten der Schaltungsblöcke LF gleich sind und ihre Ausgänge nur zur nächsten Zellreihe von Schaltungsblöcke führen, bildet sich eine parallele nach unten gerichtete Wellenfront WF1 aus, die dann in der Reihe Q-LF oberhalb des Slave-Zwischenspeicherelemente S-LA in eine schräge Wellenfront durch die Schaltungsblöcke LF' verändert wird, da in dieser Reihe die Schaltungsblöcke LF' auch horizontale Ausgänge zu ihren Nachbarschaltungsblöcken besitzen. In den höherwertigen Bitpositionen treten infolge dessen dynamische Hazards auf, weil das Eintreffen der vertikalen und horizontalen Datensignale unterschiedlich ist. Es bildet sich eine schräge Wellenfront WF2 aus, die sich nach unten fortsetzt und auch dort zu dynamischen Hazards führt. Da die Schaltungsblöcke am linken Rand die größten Unterschiede beim Eintreffen der Datensignale haben, ist bei ihnen die Gefahr dynamischer Hazards am größten.

In Fig. 4 ist die Position der Wellenfronten WF1, WF2 durch die gestrichelten Linien angedeutet. Oberhalb des Zwischenspeicherelementes S-LA ist die Wellenfront waagrecht, unterhalb des Zwischenspeicherelementes S-LA dagegen schräg.

Um dynamische Hazards zu vermeiden, muß die Schaltung so beeiflußt werden, daß die ursprüngliche Wellenfront WF1 wiederhergestellt wird und damit das Auftreten dynamischer Hazards in den nachfolgenden Schaltungsblöcken verhindert wird. Eine Beeinflussung der Wellenfront kann mit Hilfe der Zwischenspeicherelemente, in Fig. 4 der Zwischenspeicherelementen S-LA, dadurch erreicht werden, daß sie mit einem Taktsignal so angesteuert werden, daß sie eine minimal lange Transparentphase haben, deren minimale Dauer durch die Eigenschaften des Zwischenspeicherelementes bedingt ist. Eine solche minimale Transparentphase für die Zwischenspeicherelemente wird mit Hilfe eines unsymmetrischen Taktsignales erreicht, das in Fig. 5 dargestellt ist und dort mit CLK0 bezeichnet ist. Durch ein solches unsymmetrisches Taktsignal CLK0 am Zwischenspeicherelement S-LK wird gewährleistet, daß die Datensignale erst dann an die den Zwischenspeicherelementen S-LA nachgeschalteten Schaltungsblöcke LF weitergegeben werden, wenn das Zwischenspeicherelement an der höherwertigsten Position der Reihe Q-LF sein Datensignal erhalten hat.

Eine Schaltungsanordnung zur Erzeugung des unsymmetrischen Taktsignales für die Zwischenspeicherelemente zeigt Fig. 6. Die Schaltungsanordnung nach Fig. 6 besteht aus einem Verzögerungselement, das z.B. aus drei invertierenden Slave-Latches (die z.B. identisch mit den in dem Datenpfad verwendeten Latches sind) und einem NAND-Gatter UG4 realisiert ist.

Die Latches sind mit LA1 bis LA3 bezeichnet. Die Schaltungsanordnung erzeugt aus dem symmetrischen Taktsignal CLK ein unsymmetrisches Taktsignal CLK0 mit einer Taktbreite der Low-Phase, die durch das Verzögerungselement definiert ist. Das verzögerte Taktsignal ist in Fig. 5 und Fig. 6 mit CLKD benannt.

Werden nun die Zwischenspeicherelemente S-LA mit dem Taktsignal CLK0 angesteuert, dann geben diese ihre Datensignale erst dann an die nachgeschalteten Schaltungsblöcke weiter, wenn gewährleistet ist, daß auch das höchstwertigste Zwischenspeicherelement sein Datensignal vom vorhergehenden Schaltungsblock erhalten hat. Damit wird aus der in Fig. 4 angedeuteten schrägen Wellenfront WF2 wieder eine horizontale Wellenfront entsprechend WF1. Dynamische Hazards werden auf diese Weise sicher vermieden.

Die in der Schaltung angeordneten Zwischenspeicherelemente können als Master-Slave-Register realisiert sein, sie können aber auch Master-Slave-Latches sein. Wenn das Master-Slave-Prinzip verwendet wird, können die Master- Zwischenspeicherelemente mit einem symmetrischen Taktsignal angesteuert werden, die Slave-Zwischenspeicherelemente dagegen mit dem unsymmetrischen Taktsignal, das aus dem symmetrischen Taktsignal gewonnen worden ist.

Literaturverzeichnis

[1] E. J. Mc Cluskey, Logic Design Principles, Prentice Hall, Englewood Cliffs, New Jersey 07632, 1986

[2] T. K. Liu, Synthesis Algorithm for 2-Levels MOS Networks, IEEE Trans. on Computers, Band C-24, Nr. 1, Januar 1975

[3] J. M. Rabaey, Low Power Digital Design, Proc. ISCA '94, London, Lecture Notes, Chapter 8, May 1994

[4] P. Landman und J. Rabaey, Power Estimation for High Level Synthesis, Proc. 1993 EDAC Conference, Paris, Feburar 1993

[5] W. Ulbrich und T. G. Noll, Design of Dedicated MOS Digital Filters for High-Speed Applications. Proc., ISCAS '1985, Kyoto, S. 255-258, Juni 1985

**Patentansprüche**

1. CMOS-Schaltung aus CMOS-Schaltungsblöcken (LF), die in bitparallelen Datenpfaden (DF) angeordnet sind,

   - bei der die Übertragung durch die Datenpfade durch ein symmetrisches Taktsignal (CLK) synchronisiert ist,
   - bei der in den Datenpfaden nach einer gleichen Anzahl von Schaltungsblöcken jeweils von einem unsymmetrischen Taktsignal (CLK0) gesteuerte, die Daten in den Datenpfaden speichernde Zwischenspeicherelemente (S-LA) angeordnet sind,
   - bei der Mittel vorgesehen sind, die aus dem Taktsignal (CLK) das unsymmetrische Taktsignal (CLK0) für die Zwischenspeicherelemente (S-LA) für die Weitergabe der Daten in den Datenpfaden erzeugen.

2. CMOS-Schaltungen nach Anspruch 1,

   - bei der zur Synchronisierung der Datenübertragung in den Datenpfaden durch das Taktsignal (CLK) als Zwischenspeicherelemente Master-Slave-Elemente (M-LA, S-LA) vorgesehen sind,
   - bei der jeweils eine Master-Einheit(M-LA), die vom symmetrischen Taktsignal (CLK) mit dessen Impulsen der einen Polarität geschaltet wird, in jedem Datenpfad nach einer gleichen Anzahl von Schaltungsblöcken angeordnet ist,
   - bei der jeweils eine Slave-Einheit (S-LA), die von dem unsymmetrischen Taktsignal (CLK0) geschaltet wird, hinter den Master-Einheiten nach einer gleichen Anzahl von Schaltungsblöcken (LF) angeordnet ist.

3. CMOS-Schaltung nach Anspruch 1 oder 2,

   - bei der das Mittel zur Erzeugung des unsymmetrischen Taktsignals (CLK0) ein NAND-Gatter (UG4) und mehrere hintereinander angeordnete Slave-Latches (LA1 bis LA3) aufweist,
   - bei der dem NAND-Gatter (UG4) das Taktsignal (CLK) direkt und über die Slave-Latches (LA1 bis LA3) verzögert zugeführt wird.

4. CMOS-Schaltung nach Anspruch 3,
   bei der die zur Verzögerung des Taktsignales (CLK) verwendeten Latches (LA1 bis LA3) im Aufbau den durch das unsymmetrische Taktsigal angesteuerten Zwischenspeicherelementen (S-LA) entsprechen.

## FIG 1

$Y_3 = 1$ — AND1 & — $Y'_1$

FF1

AND3 & UG3

$Y_1$

S

RS-Flip-Flop

UG1

X

FF2

S

RS-Flip-Flop

$\overline{Y}_1$

R

AND2 & τ — $\overline{Y'}_1$

UG2

$Y_3 = 1$

$Y_4 = 0$ — R

## FIG 2

$Y_1, Y'_1$

$\overline{Y}_1$

$\overline{Y'}_1$

X

Hazard

## FIG 3

0 → FA 1

0 →

0 → FB 2

0 →

0 → FC 3

0 →

0 → FA' 1

0 →

0 → FC' 2

0 → FB' 1

0 →

FIG 4

## FIG 5

CLK

CLKD

CLKO

## FIG 6

CLK

| LA1 | LA2 | LA3 | & |
| D Latch CLL | D Latch CLL | D Latch CLL | |

CLKD

CLKO

UG4

'1'